# EUROPEAN PATENT SPECIFICATION

(11) **EP 4 746 146 B1**
(45) Date of publication and mention of the grant of the patent: **18.11.2026**
(21) Application number: 25159851.2
(22) Date of filing: 25.02.2025
(51) Int. Cl.: H01M 50/204, H02J 7/00, H05K 7/14, H02J 7/70

(54) **ENERGY STORAGE SYSTEM**
ENERGIESPEICHERSYSTEM
SYSTÈME DE STOCKAGE D'ÉNERGIE

(30) Priority: 18.11.2024 CN 202411650741
(43) Date of publication of application: 20.05.2026
(73) Proprietor: Zhejiang Jinko Energy Storage Co., Ltd., Jiaxing, Zhejiang (CN)
(72) Inventor: YU, Jian, Jiaxing, Zhejiang (CN); SUN, Xuebing, Jiaxing, Zhejiang (CN); ZHANG, Luhua, Jiaxing, Zhejiang (CN); XU, Guodong, Jiaxing, Zhejiang (CN)
(74) Representative: DREISS Patentanwälte PartG mbB

(56) References cited:
- CN-U- 215 732 001
- CN-U- 217 984 867
- CN-U- 221 042 068
- US-A1- 2015 303 418

## Description

The present disclosure relates to an energy storage system.

### BACKGROUND

With the development of technologies, the application of photovoltaic energy storage has become increasingly widespread. An energy storage system includes a container, a high-voltage box, and a power conversion system. Typically, the high-voltage box is installed inside the container, while the power conversion system is placed outside the container. As a result, the high-voltage box occupies a relatively large space. Document CN 221 042 068 U discloses a high-voltage box, which can be used in a battery rack, and also discloses a breaker mounting plate, on which a circuit breaker is mounted inside the box together with further electric components. Further prior art is disclosed in documents CN 215 732 001 U, CN 217 984 867 U and US 2015/303418 A1.

### SUMMARY

In view of this, an energy storage system is proposed for reducing the volume of the high-voltage box, according to the subject-matter of claim 1.

According to the invention, there is provided an energy storage system, including an energy storage cabinet, a high-voltage box, and at least two power conversion systems. The high-voltage box and the power conversion systems are located within the energy storage cabinet, and the at least two power conversion systems are electrically connected to the high-voltage box. The high-voltage box includes: a box body provided with an accommodating cavity; electronic components located within the accommodating cavity; at least two circuit breakers electrically connected to the electronic components through connecting members; a first mounting bracket configured to install the at least two circuit breakers to the box body. The first mounting bracket includes a first main body portion and a second main body portion that are connected to each other, and the first main body portion is detachably installed within the accommodating cavity. Along a height direction of the high-voltage box, each of the at least two circuit breakers is sequentially installed to the second main body portion, and the at least two circuit breakers can be installed to or removed from the high-voltage box together with the first mounting bracket. The electronic components are located on a side of the second main body portion away from the at least two circuit breakers. The high-voltage box further includes at least one support member, one end of the support member is connected to the connecting members, and the other end is connected to the first mounting bracket.

In one or more embodiments, the box body is provided with a snap-fit portion, and the first mounting bracket is provided with a first mating portion. The snap-fit portion is provided on a bottom wall of the accommodating cavity and protrudes in a direction away from the bottom wall. The included angle between the snap-fit portion and the bottom wall is an acute angle, the space between the snap-fit portion and the bottom wall is a snap-fit space, and at least part of the first mating portion can extend into the snap-fit space. The first mating portion is provided with at least one mating groove, and when the snap-fit portion cooperates with the first mating portion, at least part of the snap-fit portion is located within the mating groove. The cooperation between the snap-fit portion and the first mating portion is configured to limit the relative position of the first mounting bracket and the box body.

In one or more embodiments, the first main body portion is provided with at least one second mating portion, the second mating portion is connected to the high-voltage box through mounting members, and along a length direction of the first main body portion, the first mating portion and the second mating portion are located at opposite ends of the first main body portion.

In one or more embodiments, the at least one support member is connected to a side of the second main body portion away from the at least two circuit breakers; and/or, the first mounting bracket is provided with a flanging, the flanging forms an included angle between and the first main body portion and/or the second main body portion, and the at least one support member is connected to the flanging.

In one or more embodiments, the first mounting bracket further includes a third main body portion, the third main body portion is located on a side of the second main body portion away from the first main body portion, one end of the third main body portion is connected to the second main body portion, and the other end is connected to the box body.

In one or more embodiments, the high-voltage box further includes a first insulating member, the first insulating member includes a first body part, a second body part, and a third body part, and the first body part and the third body part are located at opposite sides of the second body part and each forms an included angle with the second body part. The first body part, the second body part, and the third body part enclose to form an accommodating space, and the at least two circuit breakers are located within the accommodating space.

In one or more embodiments, each of the connecting members includes a first connecting section, a second connecting section, and at least one transition section, and the first connecting section and the second connecting section are connected through the transition section. The transition section forms an included angle with the first connecting section and/or the second connecting section. The first connecting section is electrically connected to the circuit breaker, and the second connecting section is electrically connected to the electronic components. The connecting members can be installed to or removed from the high-voltage box together with the at least two circuit breakers.

In one or more embodiments, the high-voltage box includes an arc-extinguisher and a second insulating member, the arc-extinguisher is located at an input end of the circuit breaker, and the second insulating member is located at an output end of the circuit breaker. The connecting members includes a first connecting member and a second connecting member, the electronic components include a fuse and a relay, one end of the first connecting member is electrically connected to a positive terminal of the output end of the circuit breaker, and the other end is electrically connected to the fuse, one end of the second connecting member is electrically connected to a negative terminal of the output end of the circuit breaker, and the other end is electrically connected to the relay. At least part of the second insulating member is located between the first connecting member and the second connecting member.

In one or more embodiments, the high-voltage box includes a second mounting bracket, and the second mounting bracket is located within the accommodating cavity. The second mounting bracket includes a mounting portion and a supporting portion, a gap between the supporting portion and a bottom wall of the accommodating cavity, and the supporting portion is connected to the box body. One of the fuse and the relay is located on a side of the mounting portion away from the bottom wall of the accommodating cavity, and the other is located on a side of the mounting portion close to the bottom wall of the accommodating cavity.

In one or more embodiments, the circuit breaker is provided with a mounting groove, and the arc-extinguisher is provided with a third mating portion. At least part of the third mating portion can extend into the mounting groove. The high-voltage box further includes a stop block, the stop block is connected to the second main body portion, and the stop block is located on a side of the arc-extinguisher away from the circuit breaker and is configured to limit the movement of the arc-extinguisher relative to the circuit breaker.

Thus, according to the invention, there is provided an energy storage system. The energy storage system includes an energy storage cabinet, a high-voltage box, and at least two power conversion systems. The high-voltage box and the power conversion systems are located in the energy storage cabinet, and the power conversion systems are electrically connected to the high-voltage box. The high-voltage box includes a box body with an accommodating cavity, at least two circuit breakers electrically connected to electronic components through connecting members, and a first mounting bracket for mounting the circuit breakers. The first mounting bracket includes a first main body portion and a second main body portion that are connected to each other. The first main body portion is detachably installed within the accommodating cavity. Along the height direction of the high-voltage box, each of the at least two circuit breakers is sequentially installed to the second main body portion. The at least two circuit breakers can be installed to or removed from the high-voltage box together with the first mounting bracket. The electronic components are located on the side of the second main body portion away from the at least two circuit breakers. The high-voltage box further includes at least one support member, one end of the support member is connected to the connecting members, and the other end is connected to the first mounting bracket. Such a design is beneficial for reducing the volume of the high-voltage box, lowering the assembly difficulty, and improving the production efficiency.

### BRIEF DESCRIPTION OF DRAWINGS

To more clearly illustrate the technical solutions of the embodiments of the present disclosure, the accompanying drawings used in the embodiments will be briefly introduced. It is appreciated that, the accompanying drawings in the following description are only some embodiments of the present disclosure.
FIG. 1 is a schematic diagram of a high-voltage box according to one or more embodiments of the present disclosure.
FIG. 2 is an internal schematic diagram of a high-voltage box according to one or more embodiments of the present disclosure.
FIG. 3 is a schematic diagram of a first mounting bracket according to one or more embodiments of the present disclosure.
FIG. 4 is a schematic diagram of a box body according to one or more embodiments of the present disclosure.
FIG. 5 is a partial enlarged view of position I in FIG. 4.
FIG. 6 is a schematic diagram of a circuit breaker and a mounting bracket according to one or more embodiments of the present disclosure.
FIG. 7 is a schematic diagram of a mounting module according to one or more embodiments of the present disclosure.
FIG. 8 is a schematic diagram of a first mounting bracket according to one or more embodiments of the present disclosure.
FIG. 9 is a cross-sectional view of a high-voltage box according to one or more embodiments of the present disclosure.
FIG. 10 is a schematic diagram of a circuit breaker according to one or more embodiments of the present disclosure.
FIG. 11 is a schematic diagram of an arc-extinguisher according to one or more embodiments of the present disclosure.
FIG. 12 is a schematic diagram of an energy storage system according to one or more embodiments of the present disclosure.

Reference signs: 1-Box body; 11-Accommodating cavity; 12-Snap-fit portion; 13-Second mounting bracket; 131-Mounting portion; 132-Supporting portion; 14-Control member; 15-Connector; 2-Electronic components; 21-Fuse; 22-Relay; 3-Circuit breaker; 31-Mounting groove; 32-Connecting rod; 4-Connecting member; 41-First connecting section; 42-Second connecting section; 43-Transition section; 44-First connecting member; 45-Second connecting member; 5-First mounting bracket; 51-First main body portion; 511-First mating portion; 511a-Mating groove; 512-Second mating portion; 513-Through-hole; 52-Second main body portion; 521-First mounting hole; 53-Flanging; 531-Third mounting hole; 54-Third main body portion; 55-Stop block; 6-Support member; 7-First insulating member; 71-First body part; 72-Second body part; 73-Third body part; 74-Avoidance groove; 8-Arc-extinguisher; 81-Third mating portion; 9-Second insulating member; 10-Energy storage cabinet; 20-High-voltage box; 201-Connection end; 30-Power conversion system.

### DESCRIPTION OF EMBODIMENTS

To better understand the technical solutions of the present disclosure, embodiments of the present disclosure will be described in detail below with reference to the accompanying drawings.

It should be clear that the described embodiments are only some of the embodiments of the present disclosure, not all of the embodiments.

The terms used in the embodiments of the present disclosure are only for the purpose of describing specific embodiments and are not intended to limit the present disclosure. The singular forms "a/an", "the" and "said" used in the embodiments of the present disclosure and the appended claims are also intended to include plural forms, unless the context clearly indicates otherwise.

It should be understood that the term "and/or" used herein is only an associated relationship describing associated objects, indicating that there can be three relationships. For example, A and/or B refers to: A exists alone, both A and B exist simultaneously, and B exists alone. In addition, the character "/" herein generally indicates an "or" relationship between the associated objects.

Photovoltaic energy storage can convert solar energy into electrical energy for storage. The energy storage container is one of the important devices for photovoltaic energy storage, and its function is to store the electrical energy collected by the photovoltaic panels. The energy storage container is usually equipped with a power conversion system (PCS) 30 and a high-voltage box 20. The power conversion system 30 is a device for storing electrical energy and can convert direct current into alternating current, thereby providing electrical energy for external devices. The high-voltage box 20 is used to control the connection or disconnection of the main electrical circuit of the system to ensure the safe operation of the battery energy storage system.

Generally, the high-voltage box 20, as an independent cabinet, is placed separately inside the container. With the development of technologies, integrating the power conversion system 30 inside the container has become a trend. Due to the limited space inside the container, integrating the power conversion system 30 inside the container will compress the assembly space of the high-voltage box 20. Therefore, new requirements are put forward for the structure of the high-voltage box 20.

Embodiments of the present disclosure provide an energy storage system. The energy storage system may include an energy storage cabinet 10, a high-voltage box 20, and a power conversion system 30. The high-voltage box 20 and the power conversion system 30 are installed in the energy storage cabinet 10.

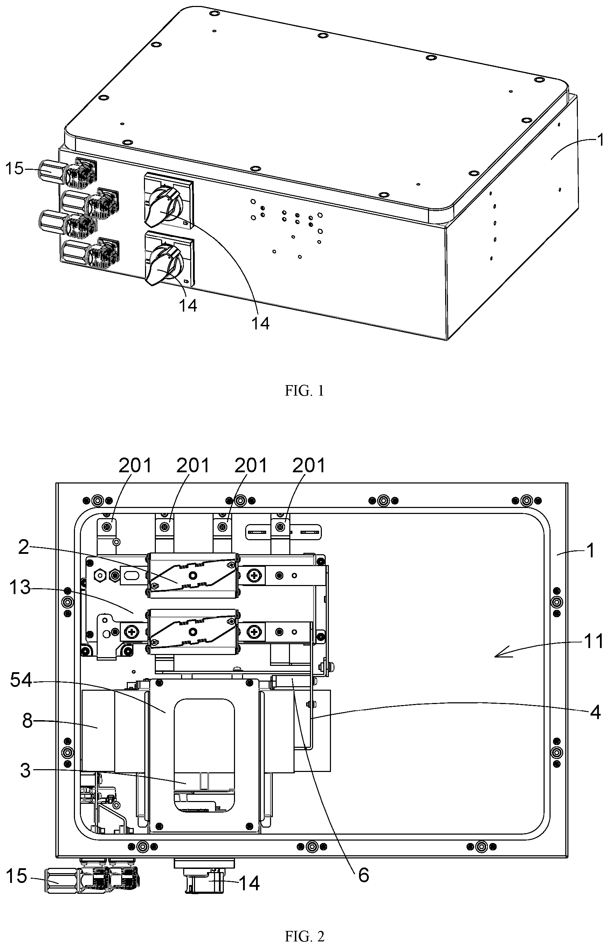

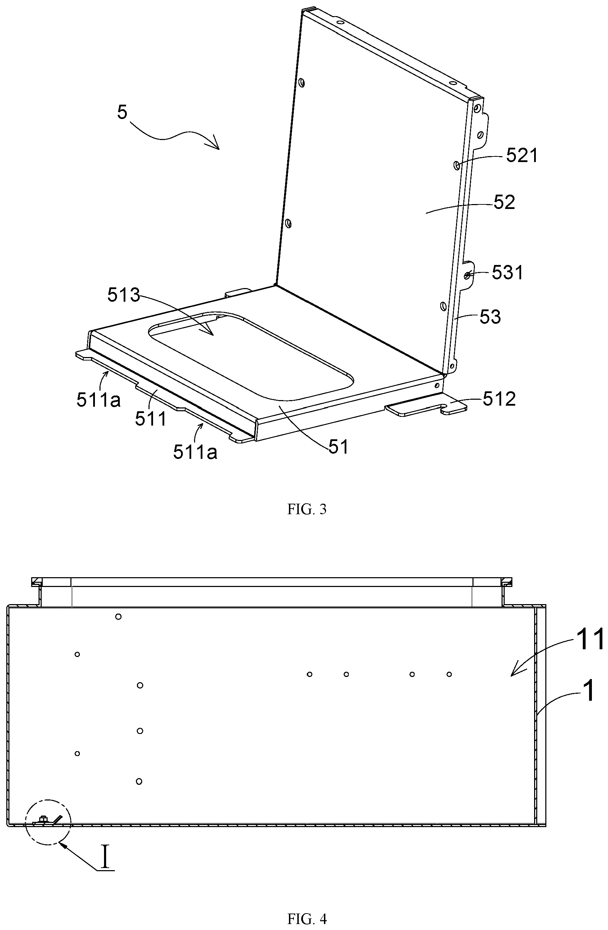

As shown in FIG. 1 and FIG. 2, embodiments of the present disclosure provide a high-voltage box 20. The high-voltage box 20 includes a box body 1, electronic components 2, a first mounting bracket 5, and at least two circuit breakers 3. The box body 1 is provided with an accommodating cavity 11, which is used to accommodate the first mounting bracket 5, the circuit breakers 3, and the electronic components 2. The circuit breakers 3 are installed to the first mounting bracket 5 and are installed to the high-voltage box 20 together with the first mounting bracket 5, or removed from the high-voltage box 20 together with the first mounting bracket 5. The circuit breakers 3 are electrically connected to the electronic components 2 through connecting members 4 and are used to control the connection or disconnection of the overall circuit of the energy storage system. As shown in FIG. 3, the first mounting bracket 5 includes a first main body portion 51 and a second main body portion 52. The first main body portion 51 and the second main body portion 52 are connected to each other and form an included angle therebetween. The first main body portion 51 and the second main body portion 52 can be arranged in an "L" shape. The first main body portion 51 is connected to the box body 1, and the circuit breakers 3 are installed to the first mounting bracket 5 through the second main body portion 52.

When assembling the high-voltage box 20, the circuit breakers 3 can be installed to the first mounting bracket 5 outside the high-voltage box 20 first, so that the circuit breakers 3 and the first mounting bracket 5 form a mounting module, and then the circuit breakers 3 and the first mounting bracket 5 are installed as a whole inside the high-voltage box 20.

When the volume of the high-voltage box 20 decreases, the internal space of the high-voltage box 20 will decrease accordingly. When directly installing the circuit breakers 3 inside the high-voltage box 20, due to the limited space, the installation operation is more difficult, resulting in a decrease in assembly efficiency. Compared with the scheme of directly installing the circuit breakers 3 within the box body 1 of the high-voltage box 20, installing the circuit breakers 3 outside the high-voltage box 20 can help increase the operating space and facilitate the operation of the operator.

The high-voltage box 20 provided by embodiments of the present disclosure includes at least two circuit breakers 3. Each circuit breaker 3 is used to control one power conversion system 30, and each circuit breaker 3 is sequentially installed to the second main body portion 52 of the first mounting bracket 5 along the thickness direction of the high-voltage box 20.

In the solutions provided by embodiments of the present disclosure, by arranging the circuit breakers 3 in sequence along the height direction of the high-voltage box 20, the space utilization rate of the high-voltage box 20 in the height direction can be improved, thereby improving the integration degree of the high-voltage box 20, making the overall structure of the high-voltage box 20 more compact, and thus helping to reduce the overall volume of the high-voltage box 20. Since the volume of the high-voltage box 20 is reduced, the internal space of the high-voltage box 20 is limited, and the operating space left for the operator when installing the circuit breakers 3 is small. When installing multiple circuit breakers 3, due to insufficient operating space, the installation is more difficult or even impossible. By adopting the solutions provided by embodiments of the present disclosure, each circuit breaker 3 can be installed to the first mounting bracket 5 outside the high-voltage box 20 in advance, so that there is enough space to install the circuit breakers 3 for the operator, reducing the operating difficulty. After the installation of the circuit breakers 3 and the first mounting bracket 5 is completed, the circuit breakers 3 and the first mounting bracket 5 are installed as a whole inside the high-voltage box 20. By modularizing the circuit breakers 3 and the first mounting bracket 5, the space utilization rate of the high-voltage box 20 can be improved, and the installation difficulty can be reduced.

As shown in FIG. 2, in one or more embodiments, one end of the connecting member 4 is connected to the circuit breaker 3, and the other end is connected to the electronic components 2. The high-voltage box 20 further includes at least one support member 6. One end of the support member 6 is connected to the connecting member 4, and the other end is connected to the first mounting bracket 5.

By providing the support member 6, the connecting member 4 can be supported, thus reducing the possibility of deformation of the connecting member 4 during use.

As shown in FIG. 3, FIG. 4, and FIG. 5, in one or more embodiments, the box body 1 is provided with a snap-fit portion 12, and the first mounting bracket 5 is provided with a first mating portion 511. The snap-fit portion 12 is used to cooperate with the first mating portion 511 to limit the relative position between the first mounting bracket 5 and the box body 1.

Connecting the first mounting bracket 5 and the box body 1 by means of snap-fit connection can help reduce the operation difficulty, thereby reducing the demand for operating space. Moreover, the snap-fit connection is also convenient for disassembly. When it is necessary to remove the circuit breakers 3 from the high-voltage box 20, it is only necessary to release the snap-fit connection between the first mounting bracket 5 and the box body 1, and the operation is relatively convenient and fast.

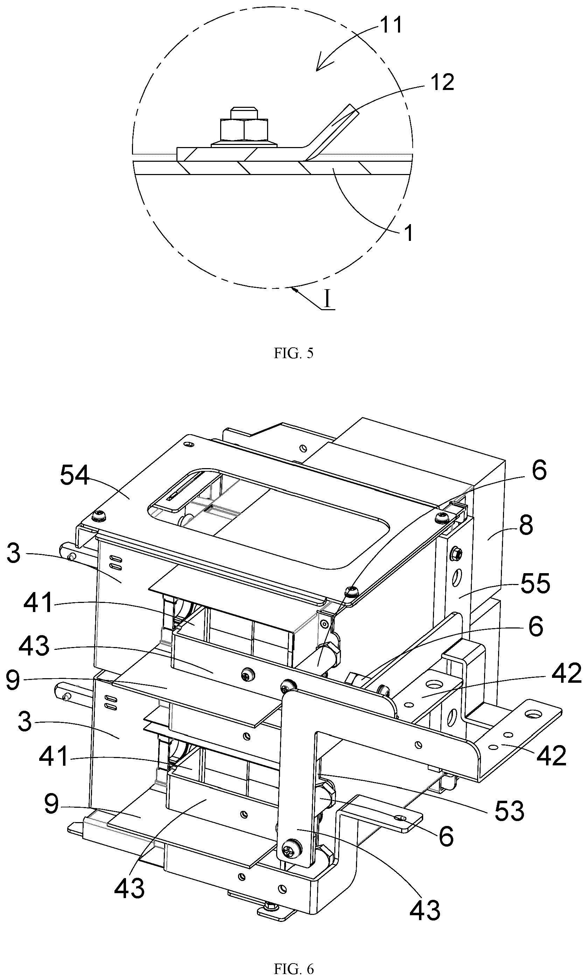

As shown in FIG. 5, in one or more embodiments, the snap-fit portion 12 is arranged on the bottom wall of the accommodating cavity 11 and protrudes in a direction away from the bottom wall. There is an included angle between the snap-fit portion 12 and the bottom wall, and the included angle is embodied as an acute angle. The space between the snap-fit portion 12 and the bottom wall of the accommodating cavity 11 can be used to form snap-fit space, and at least part of the first mating portion 511 can extend into the snap-fit space for snap-fit connection.

Such a design can facilitate the connection between the first mounting bracket 5 and the box body 1. When the first mating portion extends into the snap-fit space, it enables the snap-fit portion 12 to achieve limitation on the first mating portion 511, and then the position of the first mounting bracket 5 can be limited, which is beneficial to improving the installation position accuracy of the first mounting bracket 5 and better meets the actual use requirements.

As shown in FIG. 3, in one or more embodiments, the first mating portion 511 is provided with at least one mating groove 511a. When the snap-fit portion 12 cooperates with the first mating portion 511, at least part of the snap-fit portion 12 is located within the mating groove 511a.

By providing the mating groove 511a, snap-fit connection can be formed through the cooperation between the snap-fit portion 12 and the mating groove 511a, which can further improve the connection stability between the snap-fit portion 12 and the first mounting bracket 5. By making the first mating portion 511 extend into the snap-fit space, the first mounting bracket 5 can be limited in the height direction of the high-voltage box 20. The manner of extending the snap-fit portion 12 into the mating groove 511a can be used to limit the shaking between the snap-fit portion 12 and the first mounting bracket 5, which is beneficial to improving the connection stability between the circuit breaker 3, the first mounting bracket 5 and the high-voltage box 20, and reducing the possibility that the circuit breaker 3 deviates from the preset position due to shaking during transportation and use, which may result in malfunction of the high-voltage box 20.

As shown in FIG. 5, in one or more embodiments, the snap-fit portion 12 is fixedly connected to the box body 1.

The snap-fit portion 12 can be a component independent of the box body 1 and is fixedly installed to the box body 1 by means of welding, bonding, threaded connection, etc. This design can adjust the position and quantity of the snap-fit portion 12 according to actual use requirements, making the configuration of the high-voltage box 20 more flexible and beneficial to improving the space utilization rate of the high-voltage box 20.

In one or more embodiments, the snap-fit portion 12 can be integrally formed with the box body 1.

By adopting the integral-forming manner, the assembling steps of the high-voltage box 20 can be reduced. The snap-fit portion 12 formed integrally has better integrity, and is suitable for mass production. Moreover, since the standardized design of the high-voltage box 20 is achieved, the versatility of the high-voltage box 20 is improved.

As shown in FIG. 3, in one or more embodiments, the first main body portion 51 is provided with at least one second mating portion 512. The second mating portion 512 can be connected to the high-voltage box 20 through mounting members such as screws and bolts. Along the length direction of the first main body portion 51, the first mating portion 511 and the second mating portion 512 are located at opposite ends of the first main body portion 51.

By providing the second mating portion 512, the contact area between the first mounting bracket 5 and the box body 1 can be increased, thereby improving the connection stability. The first mating portion 511 and the second mating portion 512 are on different sides of the first main body portion 51. During installation, the first mounting bracket 5 and the box body 1 can be connected in different positions, thus enhancing the installation stability of the first mounting bracket 5 and reducing the possibility of the first mounting bracket 5 shaking during transportation and use.

As shown in FIG. 3, in one or more embodiments, the first main body portion 51 is provided with a through-hole 513, and the through-hole 513 penetrates through the first main body portion 51 along the thickness direction of the high-voltage box 20.

By providing the through-hole 513 on the first main body portion 51, it can be used to receive wire harnesses. During the assembly process, the wire harnesses can pass through the through-hole 513. In addition, the through-hole 513 also has the function of weight reduction, which is beneficial for reducing the weight of the first mounting bracket 5 and thus reducing the overall weight of the high-voltage box 20.

As shown in FIG. 3, in one or more embodiments, the second main body portion 52 is provided with a first mounting hole 521, and the circuit breaker 3 is installed to the first mounting bracket 5 through the first mounting hole 521.

By providing the first mounting hole 521, it is convenient for the connection of the circuit breaker 3 and the first mounting bracket 5.

As shown in FIG. 6, in one or more embodiments, at least one support member 6 is connected to the side of the second main body portion 52 away from the circuit breaker 3.

One end of the support member 6 is connected to the connecting member 4, and the other end is connected to the first mounting bracket 5. Through this design, the connecting member 4 can be well supported.

In the scheme of directly installing the circuit breaker 3 within the high-voltage box 20 in the related art, since the first mounting bracket 5 is not provided, when the size of the connecting member 4 is large and the connecting member 4 needs to be supported, the connecting member 4 can only be arranged along the inner wall of the high-voltage box 20, and a support structure is provided on the inner wall of the high-voltage box 20. In this way, the connecting member 4 generally has a straight-line structure. Therefore, the relative position of the circuit breakers 3 and the electronic components 2 electrically connected to the circuit breakers 3 may be affected by the support structure. The electronic components 2 can only be located on the side where the output end of the circuit breaker 3 is provided, resulting in limitations on the overall layout of the high-voltage box 20. It is not conducive to the optimal design of the internal structure of the high-voltage box 20, leading to an increase in the volume of the high-voltage box 20. Moreover, since the support member 6 is provided on the inner wall of the box body 1, during installation, operations need to be carried out inside the box body 1. However, the space inside the box body 1 is limited, resulting in increased connection difficulty and affecting the assembly efficiency.

In the solutions provided by embodiments of the present disclosure, by providing the first mounting bracket 5, the support member 6 can be provided on the first mounting bracket 5. Therefore, the position of the electronic components 2 can be adjusted according to the layout requirements of the high-voltage box 20. The connecting member 4 can be set as an irregular-shaped connecting member 4. That is, the connecting member 4 is not necessarily in a straight-line structure. The connecting member 4 can include one or more bent sections, and the connecting member 4 is supported by the support member 6. Thus, the electronic components 2 can be arranged on the side of the second main body portion 52 away from the circuit breakers 3. In other words, the electronic components 2 is not limited to the side where the output end of the circuit breaker 3 is.

Furthermore, during the process of assembling the high-voltage box 20, the connecting member 4 can be electrically connected to the circuit breakers 3 in advance and connected to the support member 6. This way only requires connecting the connecting member 4 and the electronic components 2 within the high-voltage box 20, which can reduce the operation steps to be performed inside the high-voltage box 20, and thus is beneficial to reducing the assembly difficulty and improving the assembly efficiency.

As shown in FIG. 6, in one or more embodiments, the first mounting bracket 5 is provided with a flanging 53. the flanging 53 forms an included angle with the first main body portion 51 and/or the second main body portion 52. At least one support member 6 is connected to the flanging 53.

Providing the flanging 53 can strengthen the first main body portion 51 and the second main body portion 52, thus improving the structural strength of the first mounting bracket 5, which better meets the actual use requirements. Moreover, by providing the flanging 53, the area of the first mounting bracket 5 can be increased. The support member 6 can be connected to the flanging 53, thereby enhancing the flexibility of arranging the support member 6, and in turn, improving the flexibility of arranging the connecting member 4. The support member 6 can be connected to one or more of the box body 1, the second main body portion 52, and the flanging 53 according to actual needs, which is beneficial for optimizing the internal structure of the high-voltage box 20 and thus reducing the volume of the high-voltage box 20.

In one or more embodiments, the support member 6 can be installed to the first mounting bracket 5 by means of welding, bonding, threaded connection, etc. The side of the second main body portion 52 away from the circuit breakers 3 may be provided with a second mounting hole and/or the flanging 53 is provided with a third mounting hole 531. Installing the support member 6 through the mounting hole can improve the positioning accuracy of the support member 6 during installation and increase the contact area between the first mounting bracket 5 and the support member 6, thus contributing to enhancing the connection stability of the support member 6, which is more in line with the actual use requirements.

As shown in FIG. 6, in one or more embodiments, the first mounting bracket 5 may also include a third main body portion 54. The third main body portion 54 is located on the side of the second main body portion 52 away from the first main body portion 51. That is, the first main body portion 51 and the third main body portion 54 are located on opposite sides of the second main body portion 52. The first main body portion 51, the second main body portion 52, and the third main body portion 54 can be used to enclose a horizontally-placed U-shaped structure, and the opening of the U-shaped structure faces the side wall of the box body 1. One end of the third main body portion 54 is connected to the second main body portion 52, and the other end is connected to the box body 1.

The third main body portion 54 can be connected to the second main body portion 52 and the box body 1 by means of threaded connection, etc., which is used to increase the contact area and connection points between the first mounting bracket 5 and the box body 1, thus improving the connection stability between the first mounting bracket 5 and the box body 1. Along the thickness direction of the high-voltage box 20, the lower part of the first mounting bracket 5 is connected to the box body 1 through the first mating portion 511 and the second mating portion 512, and the upper part of the first mounting bracket 5 is connected to the box body 1 through the third main body portion 54. This can help reduce the possibility of the first mounting bracket 5 shaking during transportation and use, thus contributing to enhancing the installation stability of the circuit breakers 3, which better meets the actual use requirements.

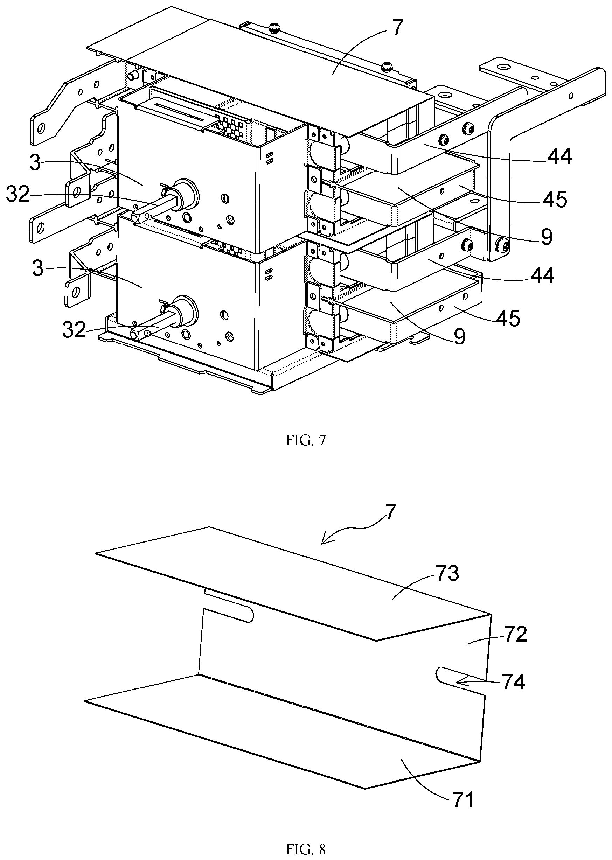

As shown in FIG. 7, in one or more embodiments, the high-voltage box 20 further includes a first insulating member 7. As shown in FIG. 8, the first insulating member 7 includes a first body part 71, a second body part 72, and a third body part 73. The first body part 71 and the third body part 73 are located on opposite sides of the second body part 72 and each form an included angle with the second body part 72. The second body part 72 and the third body part 73 are used to enclose an accommodating space, and the circuit breakers 3 are provided within the corresponding accommodating space.

The first insulating member 7 can be in an approximate U-shaped structure, covering the outside of the circuit breaker 3 for insulation, reducing the possibility of contact between adjacent circuit breakers 3, thereby improving the operational stability and safety of the high-voltage box 20.

As shown in FIG. 8, in one or more embodiments, the first insulating member 7 may also include an avoidance groove 74, which is used to provide room for the connection position between the circuit breaker 3 and the first mounting bracket 5.

The avoidance groove 74 can be provided on the second body part 72. During assembly, along the thickness direction of the high-voltage box 20, the first body part 71 and the third body part 73 are located on opposite sides of the circuit breaker 3, and the second body part 72 is located on the side of the circuit breaker 3 facing the second main body portion 52. By providing the avoidance groove 74, the interference of the first insulating member 7 with the connection position between the circuit breaker 3 and the first mounting bracket 5 can be reduced, thus decreasing the impact of the connecting member 4 on the installation stability of the circuit breaker 3, which better meets the actual use requirements.

In one or more embodiments, the first insulating member 7 can be insulating paper.

Insulating paper has good insulating properties and high strength, and can withstand the pressure of high-voltage electric fields and mechanical stresses, which can ensure the normal operation of the high-voltage box 20. In addition, insulating paper also has good thermal-resistant capabilities. When the high-voltage box 20 is applied outdoors, it can adapt to different environments, which is more in line with the actual use requirements.

As shown in FIG. 6, in one or more embodiments, the connecting member 4 includes a first connecting section 41, a second connecting section 42, and at least one transition section 43. The first connecting section 41 and the second connecting section 42 are connected through the transition section 43, and the transition section 43 forms an included angle with and the first connecting section 41 and/or the second connecting section 42. The first connecting section 41 is electrically connected to the circuit breaker 3, the second connecting section 42 is electrically connected to the electronic components 2, and the connecting member 4 can be installed to or removed from the high-voltage box 20 together with the circuit breaker 3.

The connecting member 4 can have a multi-section structure. The relative position of the first connecting section 41 and the second connecting section 42 are arranged according to the relative position of the circuit breaker 3 and the electronic components 2, and the first connecting section 41 and the second connecting section 42 are connected through the transition section 43, making the relative position between the circuit breaker 3 and the electronic components 2 more flexible. This improves the utilization rate of the internal space of the high-voltage box 20 and helps to reduce the volume of the high-voltage box 20.

In one or more embodiments, the extending directions of the first connecting section 41 and the second connecting section 42 can be parallel, and there can be one or more transition sections 43 between the first connecting section 41 and the second connecting section 42. The connecting member 4 can be integrally formed or formed as a segmented structure connected by mounting members such as screws and bolts or by means of welding, bonding, etc.

When the connecting member 4 is integrally formed, it has better integrity, as well as good strength and precision.

When the connecting member 4 has a segmented structure, the structure of the connecting member 4 is more flexible. Transition sections 43 with different structures can be pre-processed. During assembly, suitable transition sections 43 can be selected for assembly according to actual needs.

As shown in FIG. 6, in one or more embodiments, at least part of the first connecting section 41 is located on the side of the second main body portion 52 close to the circuit breaker 3, and at least part of the second connecting section 42 is located on the side of the second main body portion 52 away from the circuit breaker 3. In the width direction of the second main body portion 52, the first connecting section 41 and the second connecting section 42 can extend beyond the second main body portion 52. That is, along the thickness direction of the second main body portion 52, the second main body portion 52 may not be provided on a part of the area between the first connecting section 41 and the second connecting section 42. This design can facilitate the arrangement of the transition section 43 and reduce the possibility of interference between the connecting member 4 and the first mounting bracket 5, which better meets the actual use requirements.

As shown in FIG. 7, in one or more embodiments, the high-voltage box 20 includes an arc-extinguisher 8 and a second insulating member 9. The arc-extinguisher 8 is located at the input end of the circuit breaker 3, and the second insulating member 9 is located at the output end of the circuit breaker 3. The connecting members 4 include a first connecting member 44 and a second connecting member 45, and the electronic components 2 include a fuse 21 and a relay 22. One end of the first connecting member 44 is electrically connected to the positive terminal of the output end of the circuit breaker 3, and the other end is electrically connected to the fuse 21. One end of the second connecting member 45 is electrically connected to the negative terminal of the output end of the circuit breaker 3, and the other end is electrically connected to the relay 22.

The arc-extinguisher 8 is used to realize the arc contact with a solid to reduce the arc temperature, so as to accelerate the arc extinction, thereby improving safety, and prolonging the service life of the high-voltage box 20. The second insulating member 9 is located between the first connecting member 44 and the second connecting member 45 to achieve insulation therebetween, reducing the possibility of short-circuit due to the electrical connection between the first connecting member 44 and the second connecting member 45, thereby enhancing the safety and stability of the high-voltage box 20.

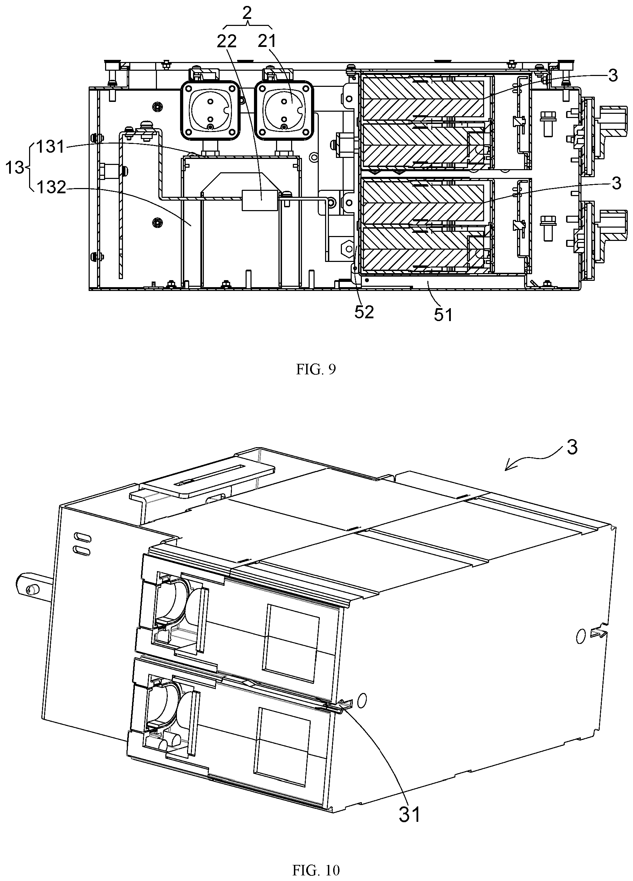

As shown in FIG. 9, in one or more embodiments, the high-voltage box 20 includes a second mounting bracket 13. The second mounting bracket 13 is located in the mounting cavity. The second mounting bracket 13 includes a mounting portion 131 and a supporting portion 132. The supporting portion 132 is connected to the mounting portion 131. The mounting portion 131 is used to install the electronic components 2, and the supporting portion 132 is connected to the box body 1. Along the thickness direction of the high-voltage box 20, there is a gap between the mounting portion 131 and the bottom wall of the accommodating cavity 11. One of the fuse 21 and the relay 22 is located on the side of the mounting portion 131 away from the bottom wall of the accommodating cavity 11, and the other is located on the side of the mounting portion 131 close to the bottom wall of the accommodating cavity 11.

This design allows the fuse 21 and the relay 22 to be arranged separately along the height direction of the high-voltage box 20, thus improving the utilization rate of the internal space of the high-voltage box 20. It reduces the space occupied by the electronic components 2 in the plane of the length and width directions of the high-voltage box 20, facilitating the optimization of the internal layout of the high-voltage box 20. As a result, the volume of the high-voltage box 20 can be reduced, which better meets the actual use requirements.

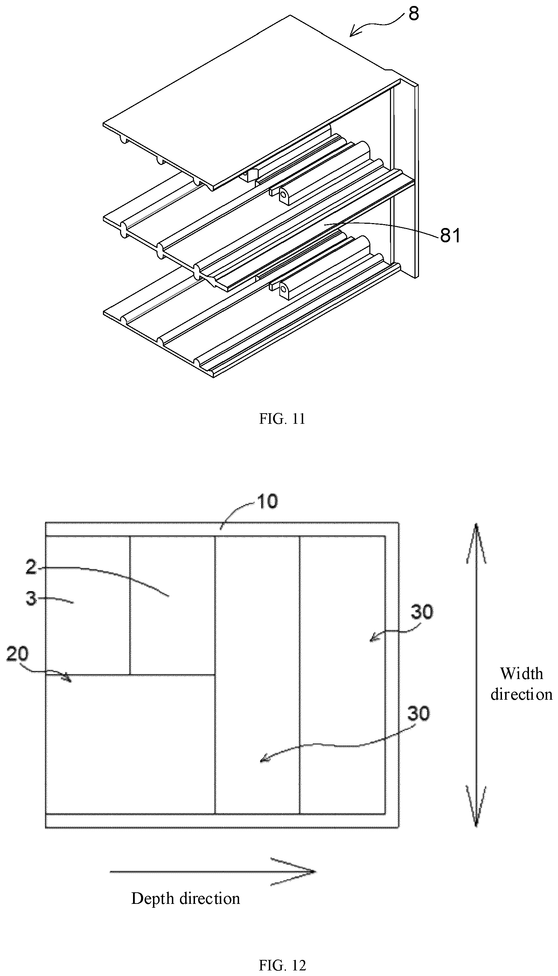

As shown in FIG. 10, in one or more embodiments, the circuit breaker 3 is provided with a mounting groove 31. As shown in FIG. 11, the arc-extinguisher 8 is provided with a third mating portion 81, and at least part of the third mating portion 81 can extend into the mounting groove 31.

During installation, the arc-extinguisher 8 can be slidably engaged with the mounting groove 31 through the third mating portion 81, and the arc-extinguisher 8 is driven to move along the mounting groove 31 to a predetermined position. This design can enhance the connection stability between the arc-extinguisher 8 and the third mating portion 81, and the operation difficulty is relatively low, which is more in line with the actual use requirements.

As shown in FIG. 6, in one or more embodiments, the high-voltage box 20 further includes a stop block 55 connected to the second main body portion 52. The stop block 55 is located on the side of the arc-extinguisher 8 away from the circuit breaker, and is used to limit the movement of the arc-extinguisher 8 relative to the circuit breaker 3. Along the installation direction of the arc-extinguisher 8, the stop block 55 can be located on the side of the arc-extinguisher 8 away from the circuit breaker 3, and the stop block 55 can abut against the arc-extinguisher 8 to limit the movement of the arc-extinguisher 8 in the direction opposite to the installation direction, thus preventing the arc-extinguisher 8 from detaching from the circuit breaker 3.

By providing the stop block 55, the arc-extinguisher 8 can be limited, thereby enhancing the installation stability of the arc-extinguisher 8 and reducing the possibility of the arc-extinguisher 8 detaching from the circuit breaker 3. This is beneficial for improving the safety and stability of the high-voltage box 20 and better meets the actual use requirements.

In one or more embodiments, the stop block 55 can be connected to the side of the second main body portion 52 away from the circuit breaker 3. The stop block 55 can be provided with an avoidance depression for structures such as the connecting member 4, reducing the possibility of interference between the stop block 55 and other internal structures of the high-voltage box 20.

As shown in FIG. 2 and FIG. 7, in one or more embodiments, the circuit breaker 3 includes a connecting rod 32. The high-voltage box 20 is provided with a connecting hole and a control member 14. The control member 14 is located outside the box body 1, and at least part of the connecting rod 32 can pass through the connecting hole and be connected to the control member 14.

This design enables the control of the circuit breaker 3 through the control member 14, which is more in line with the actual use requirements.

As shown in FIG. 2, in one or more embodiments, the high-voltage box 20 further includes a connector 15. The connector 15 is located outside the box body 1, and the input end of the circuit breaker 3 is connected to the connector 15.

The connector 15 can be used for electrical connection with the battery compartment.

When assembling the high-voltage box 20 provided by embodiments of the present disclosure, the first insulating member 7 can be first provided on the first mounting bracket 5, and the circuit breaker 3 is fixedly connected to the first mounting bracket 5. The first insulating member 7 can be arranged along the circumference of the circuit breaker 3 to protect the circuit breaker 3. Connecting members 4 such as copper bars are installed at the inlet and output ends of the circuit breaker 3 accordingly. After the at least two circuit breakers 3 are installed to the first mounting bracket 5 as required, the first mounting bracket 5, the circuit breakers 3, and the connecting members 4 are installed together within the box body 1.

This design can modularize the circuit breakers 3, the connecting members 4, and the first mounting bracket 5. Performing modular installation outside the high-voltage box 20 can reduce the space requirements for the box body 1, as well as the requirements for the operating space. Therefore, the volume of the high-voltage box 20 can be reduced. In addition, the installation operation outside the box provides a relatively large operating space, which can reduce the operation difficulty. The assembly is more convenient and faster, thus improving the assembly efficiency of the high-voltage box 20, which better meets the actual use requirements.

Based on the high-voltage box 20 provided by the above-mentioned embodiments, embodiments of the present disclosure also provide an energy storage system. The energy storage system includes an energy storage cabinet 10, a high-voltage box 20, and at least two power conversion systems 30. The high-voltage box 20 and the power conversion systems 30 are located within the energy storage cabinet 10. The energy storage cabinet 10 can be in the structure of a container, etc. The power conversion system 30 is electrically connected to the input end of the circuit breaker 3 of the high-voltage box 20. The high-voltage box 20 can be the high-voltage box 20 involved in any of the above-mentioned embodiments. Since the high-voltage box 20 has the above-mentioned technical effects, the energy storage system including this high-voltage box 20 also has corresponding technical effects, which will not be elaborated herein.

As shown in FIG. 12, the embodiments of the present disclosure provide an energy storage cabinet 10. The high-voltage box 20 and the power conversion system 30 are installed in the cavity of the energy storage cabinet 10, and the power conversion system 30 is located on one side of the high-voltage box 20. In one or more embodiments, the high-voltage box 20 is located on the side of the power conversion system 30 close to the door of the energy storage cabinet 10. That is, the installation position of the high-voltage box 20 is arranged further outward compared to the power conversion system 30. At least two power conversion systems 30 are located on the side of the high-voltage box 20 away from the door and are arranged in sequence. The electronic components 2 are provided on the side of the high-voltage box 20 close to the power conversion system 30. This design can facilitate the electrical connection between the electronic components 2 and the power conversion system 30, and reduce the wiring distance of electrical connection structures such as copper bars inside the high-voltage box 20. Thus, the internal structure of the high-voltage box 20 can be optimized, which is beneficial for reducing the volume of the high-voltage box 20. Due to the limited width of the energy storage cabinet 10, the power conversion system 30 needs to be arranged on one side of the high-voltage box 20 along the depth direction of the cavity, that is, the power conversion system 30 is located on the side of the high-voltage box 20 away from the door, which can save the space of the energy storage cabinet 10 in the width direction and is beneficial for reducing the size of the energy storage cabinet 10.

As shown in FIG. 12, along the width direction of the energy storage cabinet 10, the circuit breaker 3 and the electronic components 2 are located on the same side of the high-voltage box 20, and the other side can be used to install components such as alternating current output copper bars, pre-charge resistors, and cooling fans. The direct current input is electrically connected to the input end of the circuit breaker 3 through the connector 15. The positive terminal of the output end of the circuit breaker 3 is electrically connected to the fuse 21, the output end of the fuse 21 is electrically connected to the relay 22, the negative terminal of the output end of the circuit breaker 3 is electrically connected to the relay 22, and the output end of the relay 22 is electrically connected to the power conversion system 30. The positive terminal of the output end of the circuit breaker 3, after passing through the fuse 21, and the negative terminal of the output end are electrically connected to the same relay. Taking the case where the high-voltage box 20 includes two circuit breakers 3 as an example, the high-voltage box 20 also includes two fuses 21 and two relays 22. The positive terminal of the output end of the first circuit breaker is electrically connected to the first fuse, the output end of the first fuse is electrically connected to the first relay, and the negative terminal of the output end of the first circuit breaker is electrically connected to the first relay. The positive terminal of the output end of the second circuit breaker is electrically connected to the second fuse, the output end of the second fuse is electrically connected to the second relay, and the negative terminal of the output end of the second circuit breaker is electrically connected to the second relay. The output ends of the relays respectively lead out positive and negative outputs. That is, the side of the high-voltage box 20 close to the power conversion system 30 has four connection ends 201 for electrical connection with the power conversion system 30.

Embodiments of the present disclosure provide an energy storage system. The energy storage system includes an energy storage cabinet 10, a high-voltage box 20, and at least two power conversion systems 30. The high-voltage box 20 and the power conversion systems 30 are located in the energy storage cabinet 10, and the power conversion system 30 is electrically connected to the high-voltage box 20. The high-voltage box 20 includes a box body 1 with an accommodating cavity 11, at least two circuit breakers 3 electrically connected to electronic components 2 through connecting members 4, and a first mounting bracket 5 for installing the circuit breakers 3. The first mounting bracket 5 includes a first main body portion 51 and a second main body portion 52 that are connected to each other. The first main body portion 51 is detachably installed within the accommodating cavity 11. Along the height direction of the high-voltage box 20, each circuit breaker 3 is sequentially installed to the second main body portion 52. The circuit breakers 3 can be installed to or removed from the high-voltage box 20 together with the first mounting bracket 5. The electronic components 2 are located on the side of the second main body portion 52 away from the circuit breakers 3. The high-voltage box 20 further includes at least one support member 6. One end of the support member 6 is connected to the connecting member 4, and the other end is connected to the first mounting bracket 5. Such a design is beneficial for reducing the volume of the high-voltage box 20, lowering the assembly difficulty, and thus improving the production efficiency.

The above are only the preferred embodiments of the present disclosure and are not intended to limit the present disclosure. For those skilled in the art, the present disclosure can have various modifications and changes. The scope of the present disclosure shall be defined by the appended claims.

## Claims

1. An energy storage system, comprising an energy storage cabinet (10), a high-voltage box (20), and at least two power conversion systems (30), the high-voltage box (20) and the at least two power conversion systems (30) are located within the energy storage cabinet (10), and the at least two power conversion systems (30) are electrically connected to the high-voltage box (20),
the high-voltage box (20) comprises:
a box body (1) provided with an accommodating cavity (11);
electronic components (2) located within the accommodating cavity (11);
at least two circuit breakers (3) electrically connected to the electronic components (2) through connecting members (4); and
a first mounting bracket (5) configured to install the at least two circuit breakers (3) to the box body (1);
the first mounting bracket (5) comprises a first main body portion (51) and a second main body portion (52) that are connected to each other, the first main body portion (51) is detachably installed within the accommodating cavity (11), along a height direction of the high-voltage box (20), each of the at least two circuit breakers (3) is sequentially installed to the second main body portion (52), the at least two circuit breakers (3) are capable of being installed to or removed from the high-voltage box (20) together with the first mounting bracket (5), and the electronic components (2) are located on a side of the second main body portion (52) away from the circuit breakers (3); and
the high-voltage box (20) further comprises at least one support member (6), the at least one support member (6) each have one end connected to one of the connecting members (4) and the other end connected to the first mounting bracket (5).

2. The energy storage system according to claim 1, **characterized in that**, the box body (1) includes a snap-fit portion (12), and the first mounting bracket (5) includes a first mating portion (511);
the snap-fit portion (12) is arranged on a bottom wall of the accommodating cavity (11) and protrudes in a direction away from the bottom wall, an included angle between the snap-fit portion (12) and the bottom wall is an acute angle, the snap-fit portion (12) and the bottom wall jointly form a snap-fit space, and at least part of the first mating portion (511) is extendable into the snap-fit space; and
the first mating portion (511) includes at least one mating groove (511a), when the snap-fit portion (12) cooperates with the first mating portion (511), at least part of the snap-fit portion (12) is located within the mating groove (511a), and cooperation between the snap-fit portion (12) and the first mating portion (511) is configured to limit relative position of the first mounting bracket (5) and the box body (1).

3. The energy storage system according to claim 2, **characterized in that**, the first main body portion (51) includes at least one second mating portion (512), the second mating portion (512) is connected to the high-voltage box (20) through mounting members, and along a length direction of the first main body portion (51), the first mating portion (511) and the second mating portion (512) are located at opposite ends of the first main body portion (51).

4. The energy storage system according to claim 1, **characterized in that**, the at least one support member (6) is connected to a side of the second main body portion (52) away from the at least two circuit breakers (3); and/or
the first mounting bracket (5) includes a flanging (53), an included angle is formed between the flanging (53) and the first main body portion (51) and/or the second main body portion (52), and the at least one support member (6) is connected to the flanging (53).

5. The energy storage system according to any one of claims 1 to 4, **characterized in that**, the first mounting bracket (5) further comprises a third main body portion (54), the third main body portion (54) is located on a side of the second main body portion (52) away from the first main body portion (51), one end of the third main body portion (54) is connected to the second main body portion (52), and the other end of the third main body portion (54) is connected to the box body (1).

6. The energy storage system according to any one of claims 1 to 4, **characterized in that**, the high-voltage box (20) further comprises a first insulating member (7), the first insulating member (7) comprises a first body part (71), a second body part (72), and a third body part (73), the first body part (71) and the third body part (73) are located at opposite sides of the second body part (72) and each form an included angle with the second body part (72), the first body part (71), the second body part (72), and the third body part (73) enclose to form an accommodating space, and the at least two circuit breakers (3) are located in the accommodating space.

7. The energy storage system according to any one of claims 1 to 4, **characterized in that**, each of the connecting members (4) comprises a first connecting section (41), a second connecting section (42), and at least one transition section (43), the first connecting section (41) and the second connecting section (42) are connected through the transition section (43), an included angle is formed between the transition section (43) and the first connecting section (41) and/or the second connecting section (42), the first connecting section (41) is electrically connected to the circuit breaker (3), the second connecting section (42) is electrically connected to the electronic components (2); and
the connecting members (4) is capable of being installed to or removed from the high-voltage box (20) together with the at least two circuit breakers (3).

8. The energy storage system according to any one of claims 1 to 4, **characterized in that**, the high-voltage box (20) comprises an arc-extinguisher (8) and a second insulating member (9), the arc-extinguisher (8) is located at an input end of the circuit breaker (3), and the second insulating member (9) is located at an output end of the circuit breaker (3);
the connecting members (4) comprises a first connecting member (44) and a second connecting member (45), the electronic components (2) comprise a fuse (21) and a relay (22), one end of the first connecting member (44) is electrically connected to a positive terminal of the output end of the circuit breaker (3), and the other end of the first connecting member is electrically connected to the fuse (21), one end of the second connecting member (45) is electrically connected to a negative terminal of the output end of the circuit breaker (3), and the other end of the second connecting member (45) is electrically connected to the relay (22); and
at least part of the second insulating member (9) is located between the first connecting member (44) and the second connecting member (45).

9. The energy storage system according to claim 8, **characterized in that**, the high-voltage box (20) comprises a second mounting bracket (13), the second mounting bracket (13) is located within the accommodating cavity (11), the second mounting bracket (13) comprises a mounting portion (131) and a supporting portion (132), a gap is provided between the supporting portion (132) and a bottom wall of the accommodating cavity (11), and the supporting portion (132) is connected to the box body (1); and
one of the fuse (21) and the relay (22) is located on a side of the mounting portion (131) away from the bottom wall of the accommodating cavity (11), and the other one of the fuse (21) and the relay (22) is located on a side of the mounting portion (131) close to the bottom wall of the accommodating cavity (11).

10. The energy storage system according to claim 8, **characterized in that**, the circuit breaker (3) includes a mounting groove (31), the arc-extinguisher (8) includes a third mating portion (81), and at least part of the third mating portion (81) is extendable into the mounting groove (31); and
the high-voltage box (20) further comprises a stop block (55), the stop block (55) is connected to the second main body portion (52), the stop block (55) is located on a side of the arc-extinguisher (8) away from the circuit breaker (3) and is configured to limit movement of the arc-extinguisher (8) relative to the circuit breaker (3).

11. The energy storage system according to any one of claims 1-10, **characterized in that**, the first main body portion (51) includes a through-hole (513), the through-hole (513) penetrates through the first main body portion (51) along a thickness direction of the high-voltage box (20) for cables to pass through.

12. The energy storage system according to any one of claims 1-10, **characterized in that**, the second main body portion (52) includes a first mounting hole (521), the circuit breaker (3) is connected to the first mounting bracket (5) through the first mounting hole (521).

13. The energy storage system according to claim 4, **characterized in that**, the second main body portion (52) includes a second mounting hole at a side away from the circuit breaker (3) for mounting the support member (6), and/or
the flanging (53) includes a third mounting hole (531) for mounting the support member (6).

14. The energy storage system according to claim 6, **characterized in that**, the first insulating member (7) includes an avoidance groove (74), the avoidance groove (74) is configured to provide room for connection position between the circuit breaker (3) and the first mounting bracket (5).

15. The energy storage system according to claim 7, **characterized in that**, at least part of the first connecting section (41) is located on a side of the second main body portion (52) close to the circuit breaker (3), and at least part of the second connecting section (42) is located on a side of the second main body portion (52) away from the circuit breaker (3).

## Patentansprüche

1. Energiespeichersystem, umfassend einen Energiespeicherschrank (10), einen Hochspannungskasten (20) und mindestens zwei Leistungsumwandlungssysteme (30), wobei der Hochspannungskasten (20) und die mindestens zwei Leistungsumwandlungssysteme (30) innerhalb des Energiespeicherschranks (10) angeordnet sind und die mindestens zwei Leistungsumwandlungssysteme (30) mit dem Hochspannungskasten (20) elektrisch verbunden sind,
wobei der Hochspannungskasten (20) umfasst:
einen Kastenkörper (1), der mit einem Aufnahmehohlraum (11) versehen ist;
elektronische Komponenten (2), die innerhalb des Aufnahmehohlraums (11) angeordnet sind;
mindestens zwei Schutzschalter (3), die durch Verbindungselemente (4) mit den elektronischen Komponenten (2) elektrisch verbunden sind; und
eine erste Montagekonsole (5), die konfiguriert ist, um die mindestens zwei Schutzschalter (3) an dem Kastenkörper (1) zu installieren;
wobei die erste Montagekonsole (5) einen ersten Hauptkörperabschnitt (51) und einen zweiten Hauptkörperabschnitt (52) umfasst, die miteinander verbunden sind, der erste Hauptkörperabschnitt (51) innerhalb des Aufnahmehohlraums (11) lösbar installiert ist, entlang einer Höhenrichtung des Hochspannungskastens (20) jeder der mindestens zwei Schutzschalter (3) nacheinander an dem zweiten Hauptkörperabschnitt (52) installiert ist, die mindestens zwei Schutzschalter (3) in der Lage sind, zusammen mit der ersten Montagekonsole (5) an dem Hochspannungskasten (20) installiert oder davon entfernt zu werden, und die elektronischen Komponenten (2) auf einer von den Schutzschaltern (3) abgewandten Seite des zweiten Hauptkörperabschnitts (52) angeordnet sind; und
wobei der Hochspannungskasten (20) ferner mindestens ein Stützelement (6) umfasst, wobei das mindestens eine Stützelement (6) jeweils ein Ende mit einem der Verbindungselemente (4) verbunden und das andere Ende mit der ersten Montagekonsole (5) verbunden aufweist.

2. Energiespeichersystem nach Anspruch 1, **dadurch gekennzeichnet, dass** der Kastenkörper (1) einen Schnappabschnitt (12) einschließt und die erste Montagekonsole (5) einen ersten Passabschnitt (511) einschließt;
der Schnappabschnitt (12) an einer Bodenwand des Aufnahmehohlraums (11) eingerichtet ist und in einer von der Bodenwand abgewandten Richtung vorsteht, ein eingeschlossener Winkel zwischen dem Schnappabschnitt (12) und der Bodenwand ein spitzer Winkel ist, der Schnappabschnitt (12) und die Bodenwand gemeinsam einen Schnappraum ausbilden und mindestens ein Teil des ersten Passabschnitts (511) in den Schnappraum ausziehbar ist; und
der erste Passabschnitt (511) mindestens eine Passnut (511a) einschließt, wenn der Schnappabschnitt (12) mit dem ersten Passabschnitt (511) zusammenwirkt, mindestens ein Teil des Schnappabschnitts (12) innerhalb der Passnut (511a) angeordnet ist, und das Zusammenwirken zwischen dem Schnappabschnitt (12) und dem ersten Passabschnitt (511) konfiguriert ist, um die relative Position der ersten Montagekonsole (5) und des Kastenkörpers (1) zu begrenzen.

3. Energiespeichersystem nach Anspruch 2, **dadurch gekennzeichnet, dass** der erste Hauptkörperabschnitt (51) mindestens einen zweiten Passabschnitt (512) einschließt, der zweite Passabschnitt (512) durch Montageelemente mit dem Hochspannungskasten (20) verbunden ist und entlang einer Längsrichtung des ersten Hauptkörperabschnitts (51) der erste Passabschnitt (511) und der zweite Passabschnitt (512) an gegenüberliegenden Enden des ersten Hauptkörperabschnitts (51) angeordnet sind.

4. Energiespeichersystem nach Anspruch 1, **dadurch gekennzeichnet, dass** das mindestens eine Stützelement (6) mit einer von den mindestens zwei Leistungsschaltern (3) abgewandten Seite des zweiten Hauptkörperabschnitts (52) verbunden ist; und/oder
die erste Montagekonsole (5) eine Bördelung (53) einschließt, ein eingeschlossener Winkel zwischen der Bördelung (53) und dem ersten Hauptkörperabschnitt (51) und/oder dem zweiten Hauptkörperabschnitt (52) ausgebildet ist, und das mindestens eine Stützelement (6) mit der Bördelung (53) verbunden ist.

5. Energiespeichersystem nach einem der Ansprüche 1 bis 4, **dadurch gekennzeichnet, dass** die erste Montagekonsole (5) ferner einen dritten Hauptkörperabschnitt (54) umfasst, der dritte Hauptkörperabschnitt (54) auf einer von dem ersten Hauptkörperabschnitt (51) abgewandten Seite des zweiten Hauptkörperabschnitts (52) angeordnet ist, ein Ende des dritten Hauptkörperabschnitts (54) mit dem zweiten Hauptkörperabschnitt (52) verbunden ist und das andere Ende des dritten Hauptkörperabschnitts (54) mit dem Kastenkörper (1) verbunden ist.

6. Energiespeichersystem nach einem der Ansprüche 1 bis 4, **dadurch gekennzeichnet, dass** der Hochspannungskasten (20) ferner ein erstes Isolierelement (7) umfasst, wobei das erste Isolierelement (7) ein erstes Körperteil (71), ein zweites Körperteil (72) und ein drittes Körperteil (73) umfasst, wobei das erste Körperteil (71) und das dritte Körperteil (73) an gegenüberliegenden Seiten des zweiten Körperteils (72) angeordnet sind und jeweils einen eingeschlossenen Winkel mit dem zweiten Körperteil (72) ausbilden, wobei das erste Körperteil (71), das zweite Körperteil (72) und das dritte Körperteil (73) umschließen, um einen Aufnahmeraum auszubilden, und die mindestens zwei Schutzschalter (3) in dem Aufnahmeraum angeordnet sind.

7. Energiespeichersystem nach einem der Ansprüche 1 bis 4, **dadurch gekennzeichnet, dass** jedes der Verbindungselemente (4) einen ersten Verbindungsbereich (41), einen zweiten Verbindungsbereich (42) und mindestens einen Übergangsbereich (43) umfasst, wobei der erste Verbindungsbereich (41) und der zweite Verbindungsbereich (42) durch den Übergangsbereich (43) verbunden sind, ein eingeschlossener Winkel zwischen dem Übergangsbereich (43) und dem ersten Verbindungsbereich (41) und/oder dem zweiten Verbindungsbereich (42) ausgebildet ist, der erste Verbindungsbereich (41) mit dem Schutzschalter (3) elektrisch verbunden ist, der zweite Verbindungsbereich (42) mit den elektronischen Komponenten (2) elektrisch verbunden ist; und
die Verbindungselemente (4) in der Lage sind, zusammen mit den mindestens zwei Leistungsschaltern (3) an dem Hochspannungskasten (20) installiert oder davon entfernt zu werden.

8. Energiespeichersystem nach einem der Ansprüche 1 bis 4, **dadurch gekennzeichnet, dass** der Hochspannungskasten (20) einen Lichtbogenlöscher (8) und ein zweites Isolierelement (9) umfasst, der Lichtbogenlöscher (8) an einem Eingangsende des Leistungsschalters (3) angeordnet ist und das zweite Isolierelement (9) an einem Ausgangsende des Leistungsschalters (3) angeordnet ist;
die Verbindungselemente (4) ein erstes Verbindungselement (44) und ein zweites Verbindungselement (45) umfassen, die elektronischen Komponenten (2) eine Sicherung (21) und ein Relais (22) umfassen, ein Ende des ersten Verbindungselements (44) mit einem positiven Anschluss des Ausgangsendes des Schutzschalters (3) elektrisch verbunden ist, und das andere Ende des ersten Verbindungselements mit der Sicherung (21) elektrisch verbunden ist, ein Ende des zweiten Verbindungselements (45) mit einem negativen Anschluss des Ausgangsendes des Schutzschalters (3) elektrisch verbunden ist, und das andere Ende des zweiten Verbindungselements (45) mit dem Relais (22) elektrisch verbunden ist; und
mindestens ein Teil des zweiten Isolierelements (9) zwischen dem ersten Verbindungselement (44) und dem zweiten Verbindungselement (45) angeordnet ist.

9. Energiespeichersystem nach Anspruch 8, **dadurch gekennzeichnet, dass** der Hochspannungskasten (20) eine zweite Montagekonsole (13) umfasst, die zweite Montagekonsole (13) innerhalb des Aufnahmehohlraums (11) angeordnet ist, die zweite Montagekonsole (13) einen Montageabschnitt (131) und einen Stützabschnitt (132) umfasst, ein Spalt zwischen dem Stützabschnitt (132) und einer Bodenwand des Aufnahmehohlraums (11) bereitgestellt ist und der Stützabschnitt (132) mit dem Kastenkörper (1) verbunden ist; und
eines von der Sicherung (21) und dem Relais (22) auf einer von der Bodenwand des Aufnahmehohlraums (11) abgewandten Seite des Montageabschnitts (131) angeordnet ist, und das andere von der Sicherung (21) und dem Relais (22) auf einer Seite des Montageabschnitts (131) nahe der Bodenwand des Aufnahmehohlraums (11) angeordnet ist.

10. Energiespeichersystem nach Anspruch 8, **dadurch gekennzeichnet, dass** der Schutzschalter (3) eine Montagenut (31) einschließt, der Lichtbogenlöscher (8) einen dritten Passabschnitt (81) einschließt und mindestens ein Teil des dritten Passabschnitts (81) in die Montagenut (31) ausziehbar ist; und
der Hochspannungskasten (20) ferner einen Anschlagblock (55) umfasst, der Anschlagblock (55) mit dem zweiten Hauptkörperabschnitt (52) verbunden ist, der Anschlagblock (55) auf einer von dem Schutzschalter (3) abgewandten Seite des Lichtbogenlöschers (8) angeordnet ist und konfiguriert ist, um eine Bewegung des Lichtbogenlöschers (8) relativ zu dem Schutzschalter (3) zu begrenzen.

11. Energiespeichersystem nach einem der Ansprüche 1 bis 10, **dadurch gekennzeichnet, dass** der erste Hauptkörperabschnitt (51) ein Durchgangsloch (513) einschließt, wobei das Durchgangsloch (513) den ersten Hauptkörperabschnitt (51) entlang einer Dickenrichtung des Hochspannungskastens (20) zum Hindurchführen von Kabeln durchdringt.

12. Energiespeichersystem nach einem der Ansprüche 1 bis 10, **dadurch gekennzeichnet, dass** der zweite Hauptkörperabschnitt (52) ein erstes Montageloch (521) einschließt, wobei der Schutzschalter (3) durch das erste Montageloch (521) mit der ersten Montagekonsole (5) verbunden ist.

13. Energiespeichersystem nach Anspruch 4, **dadurch gekennzeichnet, dass** der zweite Hauptkörperabschnitt (52) an einer von dem Schutzschalter (3) abgewandten Seite ein zweites Montageloch zum Montieren des Stützelements (6) einschließt, und/oder
die Bördelung (53) ein drittes Montageloch (531) zum Montieren des Stützelements (6) einschließt.

14. Energiespeichersystem nach Anspruch 6, **dadurch gekennzeichnet, dass** das erste Isolierelement (7) eine Ausweichnut (74) einschließt, wobei die Ausweichnut (74) konfiguriert ist, um Platz für eine Verbindungsposition zwischen dem Leistungsschalter (3) und der ersten Montagekonsole (5) bereitzustellen.

15. Energiespeichersystem nach Anspruch 7, **dadurch gekennzeichnet, dass** mindestens ein Teil des ersten Verbindungsabschnitts (41) auf einer Seite des zweiten Hauptkörperabschnitts (52) nahe dem Schutzschalter (3) angeordnet ist und mindestens ein Teil des zweiten Verbindungsabschnitts (42) auf einer Seite des zweiten Hauptkörperabschnitts (52) abgewandt von dem Schutzschalter (3) angeordnet ist.

## Revendications

1. Système de stockage d'énergie, comprenant une armoire de stockage d'énergie (10), un boîtier haute tension (20) et au moins deux systèmes de conversion de puissance (30), le boîtier haute tension (20) et les au moins deux systèmes de conversion de puissance (30) sont localisés au sein de l'armoire de stockage d'énergie (10), et les au moins deux systèmes de conversion de puissance (30) sont connectés électriquement au boîtier haute tension (20),
le boîtier haute tension (20) comprend :
un corps de boîtier (1) pourvu d'une cavité de réception (11) ;
des composants électroniques (2) localisés au sein de la cavité de réception (11) ;
au moins deux disjoncteurs (3) connectés électriquement aux composants électroniques (2) par le biais d'éléments de connexion (4) ; et
une première console de montage (5) conçue pour installer les au moins deux disjoncteurs (3) sur le corps de boîtier (1) ;
la première console de montage (5) comprend une première portion de corps principale (51) et une deuxième portion de corps principale (52) qui sont reliées l'une à l'autre, la première portion de corps principale (51) est installée de manière détachable au sein de la cavité de réception (11), le long d'une direction en hauteur du boîtier haute tension (20), chacun des au moins deux disjoncteurs (3) est installé séquentiellement sur la deuxième portion de corps principale (52), les au moins deux disjoncteurs (3) peuvent être installés sur le, ou retirés du, boîtier haute tension (20) conjointement avec la première console de montage (5), et les composants électroniques (2) sont localisés sur un côté de la deuxième portion de corps principale (52) à l'écart des disjoncteurs (3) ; et
le boîtier haute tension (20) comprend en outre au moins un élément de support (6), chacun parmi l'au moins un élément de support (6) a une extrémité reliée à l'un des éléments de connexion (4) et l'autre extrémité reliée à la première console de montage (5).

2. Système de stockage d'énergie selon la revendication 1, **caractérisé en ce que**, le corps de boîtier (1) comporte une portion à encliqueter (12), et la première console de montage (5) comporte une première portion d'accouplement (511) ;
la portion à encliqueter (12) est agencée sur une paroi inférieure de la cavité de réception (11) et fait saillie dans une direction à l'écart de la paroi inférieure, un angle inclus entre la portion à encliqueter (12) et la paroi inférieure est un angle aigu, la portion à encliqueter (12) et la paroi inférieure forment conjointement un espace d'encliquetage, et au moins une partie de la première portion d'accouplement (511) peut s'étendre dans l'espace d'encliquetage ; et
la première portion d'accouplement (511) comporte au moins une rainure d'accouplement (511a), lorsque la portion à encliqueter (12) coopère avec la première portion d'accouplement (511), au moins une partie de la portion à encliqueter (12) est localisée au sein de la rainure d'accouplement (511a), et une coopération entre la portion à encliqueter (12) et la première portion d'accouplement (511) est conçue pour limiter une position relative de la première console de montage (5) et du corps de boîtier (1).

3. Système de stockage d'énergie selon la revendication 2, **caractérisé en ce que**, la première portion de corps principale (51) comporte au moins une deuxième portion d'accouplement (512), la deuxième portion d'accouplement (512) est reliée au boîtier haute tension (20) par le biais d'éléments de montage, et le long d'une direction en longueur de la première portion de corps principale (51), la première portion d'accouplement (511) et la deuxième portion d'accouplement (512) sont localisées au niveau d'extrémités opposées de la première portion de corps principale (51).

4. Système de stockage d'énergie selon la revendication 1, **caractérisé en ce que**, l'au moins un élément de support (6) est relié à un côté de la deuxième portion de corps principale (52) à l'écart des au moins deux disjoncteurs (3) ; et/ou
la première console de montage (5) comporte un bordage (53), un angle inclus est formé entre le bordage (53) et la première portion de corps principale (51) et/ou la deuxième portion de corps principale (52), et l'au moins un élément de support (6) est relié au bordage (53).

5. Système de stockage d'énergie selon l'une quelconque des revendications 1 à 4, **caractérisé en ce que**, la première console de montage (5) comprend en outre une troisième portion de corps principale (54), la troisième portion de corps principale (54) est localisée sur un côté de la deuxième portion de corps principale (52) à l'écart de la première portion de corps principale (51), une extrémité de la troisième portion de corps principale (54) est reliée à la deuxième portion de corps principale (52), et l'autre extrémité de la troisième portion de corps principale (54) est reliée au corps de boîtier (1).

6. Système de stockage d'énergie selon l'une quelconque des revendications 1 à 4, **caractérisé en ce que**, le boîtier haute tension (20) comprend en outre un premier élément isolant (7), le premier élément isolant (7) comprend une première partie de corps (71), une deuxième partie de corps (72) et une troisième partie de corps (73), la première partie de corps (71) et la troisième partie de corps (73) sont localisées au niveau de côtés opposés de la deuxième partie de corps (72) et forment chacune un angle inclus avec la deuxième partie de corps (72), la première partie de corps (71), la deuxième partie de corps (72) et la troisième partie de corps (73) se rejoignent pour former un espace de réception, et les au moins deux disjoncteurs (3) sont localisés dans l'espace de réception.

7. Système de stockage d'énergie selon l'une quelconque des revendications 1 à 4, **caractérisé en ce que**, chacun des éléments de connexion (4) comprend une première section de connexion (41), une seconde section de connexion (42) et au moins une section de transition (43), la première section de connexion (41) et la seconde section de connexion (42) sont reliées par le biais de la section de transition (43), un angle inclus est formé entre la section de transition (43) et la première section de connexion (41) et/ou la seconde section de connexion (42), la première section de connexion (41) est connectée électriquement au disjoncteur (3), la seconde section de connexion (42) est connectée électriquement aux composants électroniques (2) ; et
les éléments de connexion (4) peuvent être installés sur le, ou retirés du, boîtier haute tension (20) conjointement avec les au moins deux disjoncteurs (3).

8. Système de stockage d'énergie selon l'une quelconque des revendications 1 à 4, **caractérisé en ce que**, le boîtier haute tension (20) comprend un extincteur d'arc (8) et un second élément isolant (9), l'extincteur d'arc (8) est localisé au niveau d'une extrémité d'entrée du disjoncteur (3), et le second élément isolant (9) est localisé au niveau d'une extrémité de sortie du disjoncteur (3) ;
les éléments de connexion (4) comprennent un premier élément de connexion (44) et un second élément de connexion (45), les composants électroniques (2) comprennent un fusible (21) et un relais (22), une extrémité du premier élément de connexion (44) est connectée électriquement à une borne positive de l'extrémité de sortie du disjoncteur (3), et l'autre extrémité du premier élément de connexion est connectée électriquement au fusible (21), une extrémité du second élément de connexion (45) est connectée électriquement à une borne négative de l'extrémité de sortie du disjoncteur (3), et l'autre extrémité du second élément de connexion (45) est connectée électriquement au relais (22) ; et
au moins une partie du second élément isolant (9) est localisée entre le premier élément de connexion (44) et le second élément de connexion (45).

9. Système de stockage d'énergie selon la revendication 8, **caractérisé en ce que**, le boîtier haute tension (20) comprend une seconde console de montage (13), la seconde console de montage (13) est localisée au sein de la cavité de réception (11), la seconde console de montage (13) comprend une portion de montage (131) et une portion de support (132), un écartement est fourni entre la portion de support (132) et une paroi inférieure de la cavité de réception (11), et la portion de support (132) est reliée au corps de boîtier (1) ; et
l'un du fusible (21) et du relais (22) est localisé sur un côté de la portion de montage (131) à l'écart de la paroi inférieure de la cavité de réception (11), et l'autre du fusible (21) et du relais (22) est localisé sur un côté de la portion de montage (131) près de la paroi inférieure de la cavité de réception (11).

10. Système de stockage d'énergie selon la revendication 8, **caractérisé en ce que**, le disjoncteur (3) comporte une rainure de montage (31), l'extincteur d'arc (8) comporte une troisième portion d'accouplement (81), et au moins une partie de la troisième portion d'accouplement (81) peut s'étendre dans la rainure de montage (31) ; et
le boîtier haute tension (20) comprend en outre un bloc d'arrêt (55), le bloc d'arrêt (55) est relié à la deuxième portion de corps principale (52), le bloc d'arrêt (55) est localisé sur un côté de l'extincteur d'arc (8) à l'écart du disjoncteur (3) et est conçu pour limiter un mouvement de l'extincteur d'arc (8) par rapport au disjoncteur (3).

11. Système de stockage d'énergie selon l'une quelconque des revendications 1 à 10, **caractérisé en ce que**, la première portion de corps principale (51) comporte un trou traversant (513), le trou traversant (513) pénètre à travers la première portion de corps principale (51) le long d'une direction d'épaisseur du boîtier haute tension (20) pour permettre à des câbles de traverser.

12. Système de stockage d'énergie selon l'une quelconque des revendications 1 à 10, **caractérisé en ce que**, la deuxième portion de corps principale (52) comporte un premier trou de montage (521), le disjoncteur (3) est relié à la première console de montage (5) par le biais du premier trou de montage (521).

13. Système de stockage d'énergie selon la revendication 4, **caractérisé en ce que**, la deuxième portion de corps principale (52) comporte un deuxième trou de montage au niveau d'un côté à l'écart du disjoncteur (3) destiné au montage de l'élément de support (6), et/ou
le bordage (53) comporte un troisième trou de montage (531) destiné au montage de l'élément de support (6).

14. Système de stockage d'énergie selon la revendication 6, **caractérisé en ce que**, le premier élément isolant (7) comporte une rainure d'évitement (74), la rainure d'évitement (74) est conçue pour fournir de la place pour une position de connexion entre le disjoncteur (3) et la première console de montage (5).

15. Système de stockage d'énergie selon la revendication 7, **caractérisé en ce que**, au moins une partie de la première section de connexion (41) est localisée sur un côté de la deuxième portion de corps principale (52) près du disjoncteur (3), et au moins une partie de la seconde section de connexion (42) est localisée sur un côté de la deuxième portion de corps principale (52) à l'écart du disjoncteur (3).
